# FASCICULE DE BREVET EUROPEEN

(11) **EP 3 799 279 B1**
(45) Date de publication et mention de la délivrance du brevet: **15.02.2023**
(21) Numéro de dépôt: 20195665.3
(22) Date de dépôt: 11.09.2020
(51) Int. Cl.: H02M 1/08, H02M 1/32, H02M 7/5387

(54) **ONDULEUR À SOURCE DE COURANT MUNI D'UN CIRCUIT DE PROTECTION**
WECHSELRICHTER MIT EINER STROMQUELLE, DIE MIT EINER SCHUTZSCHALTUNG AUSGESTATTET IST
CURRENT SOURCE INVERTER PROVIDED WITH A PROTECTIVE CIRCUIT

(30) Priorité: 24.09.2019 FR 1910530
(43) Date de publication de la demande: 31.03.2021
(73) Titulaire: Commissariat à l'Energie Atomique et aux Energies Alternatives, 75015 Paris (FR)
(72) Inventeur: PEREZ, Gaëtan, 38054 GRENOBLE CEDEX 9 (FR); BIER, Anthony, 38054 GRENOBLE CEDEX 9 (FR); CATELLANI, Stéphane, 38054 GRENOBLE CEDEX 9 (FR)
(74) Mandataire: Cabinet Beaumont

(56) Documents cités:
- JP-A- S61 244 276
- JP-A- S62 160 079

## Description

### Domaine technique

La présente description concerne de façon générale le domaine des circuits électroniques. Elle concerne plus particulièrement le domaine des onduleurs à source de courant et vise notamment un circuit de protection d'un onduleur à source de courant.

### Technique antérieure

Un onduleur est un circuit électronique permettant de générer des tensions et courants d'alimentation alternatifs à partir d'une source d'alimentation continue.

Les onduleurs le plus souvent utilisés dans l'industrie sont des onduleurs dits à source de tension, ou onduleurs à entrée en tension, c'est-à-dire qu'ils comprennent un condensateur connecté en parallèle de la source d'alimentation continue en entrée de l'onduleur.

On a également proposé des onduleurs dits à source de courant aussi appelés CSI (de l'anglais « Current Source Inverter »), ou onduleurs à entrée en courant, comportant une inductance connectée en série avec la source d'alimentation continue en entrée de l'onduleur.

Les documents JP S62 160079 A et JP S61 244276 A décrivent des onduleur à source de courant comprenant un circuit de protection contre une mise en circuit ouvert d'une source de courant d'entrée de l'onduleur.

Il serait souhaitable d'améliorer au moins en partie certains aspects des onduleurs à source de courant connus. Résumé de l'invention

Pour cela, un mode de réalisation prévoit un onduleur à source de courant tel que divulgué dans la revendication 1.

Selon un mode de réalisation, pour chaque interrupteur de puissance de la première cellule de commutation, le circuit de commande de l'interrupteur de protection de l'interrupteur de puissance est configuré pour commander l'interrupteur de protection à l'état fermé lorsqu'au moins l'un du ou des autres interrupteurs de puissance de la première cellule de commutation est à l'état fermé, et pour commander l'interrupteur de protection à l'état ouvert lorsqu'aucun autre interrupteur de puissance de la première cellule de commutation n'est à l'état fermé.

Selon un mode de réalisation, la première cellule de commutation comprend en outre un troisième interrupteur de puissance reliant le premier noeud d'entrée de l'onduleur à un troisième noeud de sortie de l'onduleur.

Selon un mode de réalisation, l'onduleur comporte en outre une deuxième cellule de commutation comportant au moins des premier et deuxième interrupteurs de puissance reliant respectivement les premier et deuxième noeuds de sortie de l'onduleur à un même deuxième noeud d'entrée de l'onduleur, et le circuit de protection comporte, pour chaque interrupteur de puissance de la deuxième cellule de commutation :
un interrupteur de protection reliant un noeud de fourniture d'un signal de commande de l'interrupteur de puissance à un noeud de commande de l'interrupteur de puissance ;
un circuit de détection de l'état ouvert ou fermé de l'interrupteur de puissance ; et
un circuit de commande de l'interrupteur de protection recevant, pour chacun du ou des autres interrupteurs de puissance de la deuxième cellule de commutation, un signal de sortie du circuit de détection de l'autre interrupteur de puissance.

Selon un mode de réalisation, pour chaque interrupteur de puissance de la deuxième cellule de commutation, le circuit de commande de l'interrupteur de protection de l'interrupteur de puissance est configuré pour commander l'interrupteur de protection à l'état fermé lorsqu'au moins l'un du ou des autres interrupteurs de puissance de la deuxième cellule de commutation est à l'état fermé, et pour commander l'interrupteur de protection à l'état ouvert lorsqu'aucun autre interrupteur de puissance de la deuxième cellule de commutation n'est à l'état fermé.

Selon un mode de réalisation, la deuxième cellule de commutation comprend en outre un troisième interrupteur de puissance reliant un troisième noeud de sortie de l'onduleur au deuxième noeud d'entrée de l'onduleur.

Selon un mode de réalisation, l'onduleur comporte en outre un circuit de détection de présence d'un courant d'entrée dans l'onduleur, chaque circuit de commande recevant un signal de sortie du circuit de détection de présence d'un courant d'entrée et étant configuré pour commander l'ouverture de l'interrupteur de protection auquel il est associé uniquement lorsqu'un courant d'entrée est détecté dans l'onduleur.

Selon un mode de réalisation, l'onduleur comporte en outre, pour chaque interrupteur de puissance, un circuit de pilotage ou circuit de commande rapprochée ayant un noeud d'entrée connecté au noeud de conduction de l'interrupteur de protection opposé au noeud de fourniture du signal de consigne de commande de l'interrupteur de puissance, et un noeud de sortie connecté au noeud de commande de l'interrupteur de puissance.

Selon un mode de réalisation, l'onduleur comporte en outre un circuit de contrôle ou circuit de commande distante commun à l'ensemble des interrupteurs de puissance et fournissant les signaux de consigne de commande des différents interrupteurs de puissance.

Selon un mode de réalisation, pour chaque interrupteur de puissance, le circuit de détection de l'état ouvert ou fermé de l'interrupteur de puissance comprend un circuit de mesure différentielle d'une tension entre le noeud de commande de l'interrupteur de puissance et un noeud de conduction de l'interrupteur de puissance.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique simplifié d'un exemple d'un onduleur à source de courant triphasé ;
la figure 2 représente de façon schématique et partielle un exemple d'un circuit de protection d'un onduleur à source de courant selon un mode de réalisation ;
la figure 3 représente plus en détail un exemple de réalisation d'un circuit de détection de l'état d'un interrupteur de puissance, du circuit de protection de la figure 2 ;
la figure 4 représente plus en détail un exemple de réalisation d'un circuit de commande d'un interrupteur de protection, du circuit de protection de la figure 2 ; et
la figure 5 est un schéma électrique simplifié d'un exemple d'un onduleur à source de courant monophasé.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des interrupteurs de puissance des onduleurs décrits ne sont pas détaillés, la réalisation de ces circuits de commande étant à la portée de l'homme du métier à partir des indications fonctionnelles de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

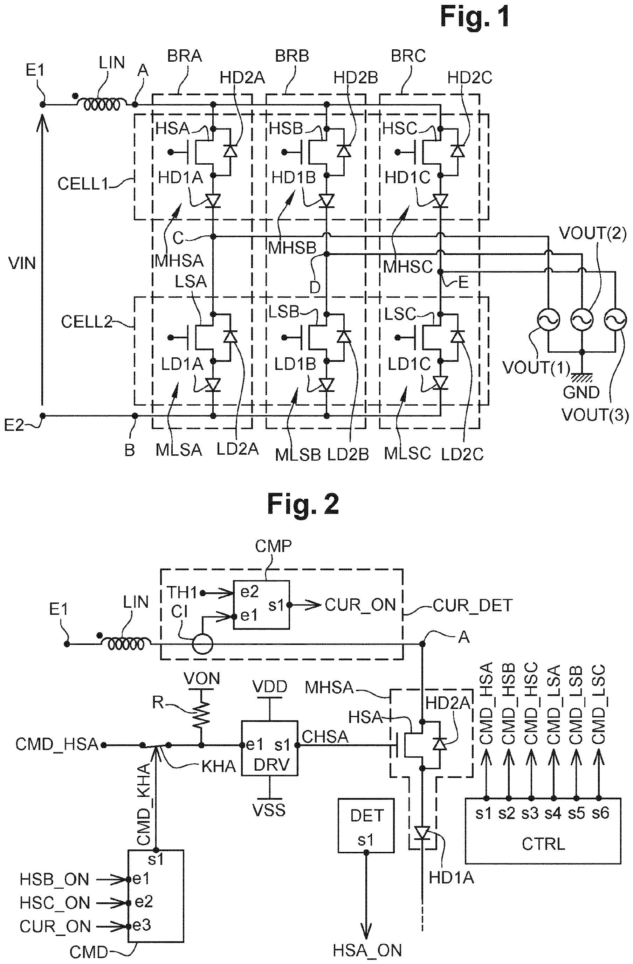

La figure 1 est un schéma électrique simplifié d'un exemple d'un onduleur à source de courant. L'onduleur de la figure 1 est un onduleur triphasé, c'est-à-dire qu'il génère une tension de sortie alternative triphasée VOUT à partir d'une tension d'entrée continue VIN.

L'onduleur de la figure 1 comprend trois bras BRA, BRB et BRC connectés en parallèle entre des noeuds A et B de l'onduleur. Chaque bras comporte deux macro-interrupteurs de puissance comportant chacun deux noeuds de conduction et un noeud de commande, reliés en série par leurs noeuds de conduction entre les noeuds A et B. Plus particulièrement, le bras BRA comprend deux macro-interrupteurs de puissance MHSA et MLSA reliés en série par leurs noeuds de conduction entre les noeuds A et B, le bras BRB comprend deux interrupteurs de puissance MHSB et MLSB reliés en série par leurs noeuds de conduction entre les noeuds A et B, et le bras BRC comprend deux interrupteurs de puissance MHSC et MLSC reliés en série par leurs noeuds de conduction entre les noeuds A et B. Les macro-interrupteurs MHSA, MHSB et MHSC sont par exemple identiques aux dispersions de fabrication près. Les macro-interrupteurs MLSA, MLSB et MLSC sont par exemple identiques aux dispersions de fabrication près. Les interrupteurs MHSA, MHSB et MHSC peuvent être identiques aux interrupteurs MLSA, MLSB et MLSC, aux dispersions de fabrication près.

Chacun des macro-interrupteurs MHSA, MHSB, MHSC, MLSA, MLSB, et MLSC est bidirectionnel en tension. Pour cela, chaque macro-interrupteur peut par exemple comporter une association de plusieurs interrupteurs. Dans l'exemple représenté, chaque macro-interrupteur comprend une association en série d'un interrupteur commandé, par exemple un transistor, et d'un interrupteur non commandé, par exemple une diode.

Plus particulièrement, dans cet exemple :
- le macro interrupteur MHSA comprend un interrupteur de puissance commandé HSA et une diode de puissance HD1A en série entre le noeud A et un noeud intermédiaire C du bras BRA,
- le macro interrupteur MLSA comprend un interrupteur de puissance commandé LSA et une diode de puissance LD1A en série entre le noeud C et le noeud B,
- le macro interrupteur MHSB comprend un interrupteur de puissance commandé HSB et une diode de puissance HD1B en série entre le noeud A et un noeud intermédiaire D du bras BRB,
- le macro interrupteur MLSB comprend un interrupteur de puissance commandé LSB et une diode de puissance LD1B en série entre le noeud D et le noeud B,
- le macro interrupteur MHSC comprend un interrupteur de puissance commandé HSC et une diode de puissance HD1C en série entre le noeud A et un noeud intermédiaire E du bras BRC,
- le macro interrupteur MLSC comprend un interrupteur de puissance commandé LSC et une diode de puissance LD1C en série entre le noeud E et le noeud B.

Chacune des diodes HD1A, HD1B, HD1C, LD1A, LD1B, LD1C est montée dans le sens direct entre le noeud A et le noeud B, c'est-à-dire que chacune des diodes HD1A, HD1B, HD1C, LD1A, LD1B, LD1C a son anode reliée au noeud A et sa cathode reliée au noeud B.

Dans l'exemple représenté :
- l'interrupteur HSA a un premier noeud de conduction connecté au noeud A et un deuxième noeud de conduction connecté à l'anode de la diode HD1A, la diode HD1A a sa cathode connectée au noeud C, l'interrupteur LSA a un premier noeud de conduction connecté au noeud C et un deuxième noeud de conduction connecté à l'anode de la diode LD1A, et la diode LD1A a sa cathode connectée au noeud B,
- l'interrupteur HSB a un premier noeud de conduction connecté au noeud A et un deuxième noeud de conduction connecté à l'anode de la diode HD1B, la diode HD1B a sa cathode connectée au noeud D, l'interrupteur LSB a un premier noeud de conduction connecté au noeud D et un deuxième noeud de conduction connecté à l'anode de la diode LD1B, et la diode LD1B a sa cathode connectée au noeud B ; et
- l'interrupteur HSC a un premier noeud de conduction connecté au noeud A et un deuxième noeud de conduction connecté à l'anode de la diode HD1C, la diode HD1C a sa cathode connectée au noeud E, l'interrupteur LSC a un premier noeud de conduction connecté au noeud E et un deuxième noeud de conduction connecté à l'anode de la diode LD1C, et la diode LD1C a sa cathode connectée au noeud B.

Les diodes HD1A, HD1B, HD1C, LD1A, LD1B, LD1C sont par exemple identiques aux dispersions de fabrication près. Les interrupteurs HSA, HSB et HSC sont par exemple identiques aux dispersions de fabrication près. Les interrupteurs LSA, LSB et LSC sont par exemple identiques aux dispersions de fabrication près. Les interrupteurs HSA, HSB et HSC peuvent être identiques aux interrupteurs LSA, LSB et LSC, aux dispersions de fabrication près.

Dans l'exemple de la figure 1, chaque macro-interrupteur comprend une diode connectée en parallèle de son interrupteur commandé. Plus particulièrement, le bras BRA comprend deux diodes HD2A et LD2A connectées respectivement en parallèle des interrupteurs HSA et LSA, le bras BRB comprend deux diodes HD2B et LD2B connectées respectivement en parallèle des interrupteurs HSB et LSB, et le bras BRC comprend deux diodes HD2C et LD2C connectées respectivement en parallèle des interrupteurs HSC et LSC. Chacune des diodes HD2A, HD2B, HD2C, LD2A, LD2B, LD2C est montée dans le sens inverse entre le noeud A et le noeud B, c'est-à-dire que chacune des diodes HD2A, HD2B, HD2C, LD2A, LD2B, LD2C a sa cathode reliée au noeud A et son anode reliée au noeud B.

Dans l'exemple représenté :
la diode HD2A a son anode reliée, par exemple connectée, à l'anode de la diode HD1A et sa cathode reliée, par exemple connectée, au noeud A ;
la diode HD2B a son anode reliée, par exemple connectée, à l'anode de la diode HD1B et sa cathode reliée, par exemple connectée, au noeud A ;
la diode HD2C a son anode reliée, par exemple connectée, à l'anode de la diode HD1C et sa cathode reliée, par exemple connectée, au noeud A ;
la diode LD2A a son anode reliée, par exemple connectée, à l'anode de la diode LD1A et sa cathode reliée, par exemple connectée, au noeud C ;
la diode LD2B a son anode reliée, par exemple connectée, à l'anode de la diode LD1B et sa cathode reliée, par exemple connectée, au noeud D ; et
la diode LD2C a son anode reliée, par exemple connectée, à l'anode de la diode LD1C et sa cathode reliée, par exemple connectée, au noeud E.

Les interrupteurs HSA, HSB, HSC, LSA, LSB, LSC sont par exemple des transistors à effet de champ, par exemple des transistors au nitrure de gallium, les noeuds de conduction des interrupteurs correspondant par exemple respectivement à des noeuds de source et de drain des transistors, et les noeuds de commande des interrupteurs correspondant à des noeuds de grille des transistors. Les diodes HD2A, HD2B, HD2C, LD2A, LD2B, LD2C correspondent par exemple à des diodes de corps intrinsèques aux transistors HSA, respectivement HSB, respectivement HSC, respectivement LSA, respectivement LSB, respectivement LSC. A titre de variante, les diodes HD2A, HD2B, HD2C, LD2A, LD2B, LD2C peuvent être des composants spécifiques distincts des transistors HSA, HSB, HSC, LSA, LSB, LSC.

A titre de variante, chacun des macro-interrupteurs MHSA, MHSB, MHSC, MLSA, MLSB, MLSC correspond à une association en série de deux interrupteurs commandés, par exemple deux transistors à effet de champ connectés en anti-série (c'est-à-dire ayant leurs diodes intrinsèques tête bêche).

L'onduleur de la figure 1 comprend en outre une inductance d'entrée LIN reliée en série avec l'association en parallèle des bras BRA, BRB et BRC, entre des noeuds E1 et E2 d'application de la tension d'entrée VIN de l'onduleur. Plus particulièrement, dans l'exemple représenté, l'inductance LIN a une première extrémité reliée, par exemple connectée, au noeud E1, et une deuxième extrémité reliée, par exemple connectée, au noeud A. Le noeud B est quant à lui relié, par exemple connecté, au noeud E2. A titre de variante, l'inductance LIN peut être scindée en deux inductances connectées respectivement entre le noeud E1 et le noeud A et entre le noeud E2 et le noeud B. Dans une autre variante, l'inductance LIN peut connectée uniquement entre les noeuds E2 et B.

L'onduleur de la figure 1 est adapté à fournir une première phase VOUT(1) de la tension alternative de sortie triphasée VOUT entre le noeud C et un noeud de référence ou neutre GND, une deuxième phase VOUT(2) de la tension alternative triphasée VOUT entre le noeud D et le noeud GND, et une troisième phase VOUT (3) de la tension alternative triphasée VOUT entre le noeud E et le noeud GND.

Pour cela, les macro-interrupteurs MHSA, MHSB, MHSC, MLSA, MLSB et MLSC sont commandés en commutation de façon périodique selon une séquence de commande appropriée.

Dans l'onduleur de la figure 1, les macro-interrupteurs MHSA, MHSB et MHSC relient le noeud E1 à respectivement trois noeuds de sortie distincts C, D et E de l'onduleur, et définissent une première cellule de commutation CELL1 de l'onduleur. Les macro-interrupteurs MLSA, MLSB et MLSC relient respectivement les noeuds C, D et E au noeud E2, et définissent une deuxième cellule de commutation CELL2.

Dans un tel onduleur, il convient de veiller à ce qu'à tout instant, au moins un macro-interrupteur de puissance de la cellule de commutation CELL1 et au moins un macro-interrupteur de puissance de la cellule de commutation CELL2 soient fermés (passants), ceci afin d'éviter une mise en circuit ouvert de la source de courant d'entrée, qui pourrait provoquer la destruction des macro-interrupteurs de puissance.

La figure 2 représente de façon schématique et partielle un exemple d'un mode de réalisation d'un onduleur à source de courant muni d'un circuit de protection contre une mise en circuit ouvert de sa source de courant d'entrée.

L'onduleur de la figure 2 comprend les mêmes éléments que l'onduleur de la figure 1, agencés sensiblement de la même manière. Par souci de simplification, parmi les éléments de la figure 1, seuls le macro-interrupteur de puissance MHSA et l'inductance d'entrée LIN ont été représentés sur la figure 2.

Dans cet exemple, l'onduleur comprend un circuit de contrôle CTRL commun à l'ensemble des macro-interrupteurs MHSA, MHSB, MHSC, MLSA, MLSB et MLSC, déterminant la séquence de commande des interrupteurs MHSA, MHSB, MHSC, MLSA, MLSB et MLSC. Le circuit de contrôle CTRL comprend par exemple un microprocesseur, ou tout autre dispositif électronique de contrôle adapté (FPGA, microcontrôleur, etc.). En fonctionnement, le circuit de contrôle CTRL fournit en parallèle, par exemple sur six noeuds de sortie distincts s1, s2, s3, s4, s5 et s6, six signaux CMD_HSA, CMD_HSB, CMD_HSC, CMD_LSA, CMD_LSB, CMD_LSC, correspondant respectivement à des consignes de commande à appliquer aux interrupteurs commandés HSA, HSB, HSC, LSA, LSB et LSC des macro-interrupteurs MHSA, MHSB, MHSC, MLSA, MLSB et MLSC. Chacun des signaux CMD_HSA, CMD_HSB, CMD_HSC, CMD_LSA, CMD_LSB, CMD_LSC est un signal binaire pouvant prendre l'un ou l'autre de deux états discrets correspondant respectivement à une consigne de commande à l'état ouvert et à une consigne de commande à l'état fermé de l'interrupteur de puissance correspondant. Le circuit de contrôle CTRL est aussi appelé circuit de commande distante.

L'onduleur de la figure 2 comprend en outre, pour chacun des interrupteurs de puissance HSA, HSB, HSC, LSA, LSB, LSC, un circuit de pilotage DRV, aussi appelé circuit de commande rapprochée.

Chacun des circuits de pilotage DRV comprend un noeud d'entrée e1 relié au noeud de sortie du circuit de contrôle CTRL fournissant le signal de consigne de commande de l'interrupteur de puissance correspondant, et un noeud de sortie s1 relié au noeud de commande de l'interrupteur de puissance.

Chacun des circuits de pilotage DRV est adapté à convertir le signal de consigne de commande CMD_HSA, respectivement CMD_HSB, respectivement CMD_HSC, respectivement CMD_LSA, respectivement CMD_LSB, respectivement CMD_LSC appliqué sur son noeud d'entrée e1 en un signal de commande correspondant CHSA, respectivement CHSB, respectivement CHSC, respectivement CLSA, respectivement CLSB, respectivement CLSC fourni sur son noeud de sortie s1, de niveau adapté à être appliqué directement sur le noeud de commande de l'interrupteur de puissance correspondant pour commander l'ouverture et la fermeture de cet interrupteur.

Sur la figure 2, par souci de simplification, seul le circuit de pilotage DRV de l'interrupteur HSA, fournissant le signal de commande CHSA, a été représenté.

Dans cet exemple, chacun des circuits de pilotage DRV comprend une borne d'application d'une tension d'alimentation basse VSS de niveau adapté à commander l'ouverture de l'interrupteur de puissance correspondant, et une borne d'application d'une tension d'alimentation haute VDD de niveau adapté à commander la fermeture de l'interrupteur de puissance correspondant. Lorsque le signal de consigne appliqué sur le noeud d'entrée e1 du circuit DRV est à un premier état correspondant à une consigne de commande en fermeture de l'interrupteur de puissance, par exemple un état haut, le circuit DRV fournit sur son noeud de sortie s1 une tension sensiblement égale à sa tension d'alimentation haute VDD, de façon à fermer le transistor de puissance. Lorsque le signal de consigne appliqué sur le noeud d'entrée e1 du circuit DRV est à un deuxième état correspondant à une consigne de commande en ouverture de l'interrupteur de puissance, par exemple un état bas, le circuit DRV fournit sur son noeud de sortie s1 une tension sensiblement égale à sa tension d'alimentation basse VSS, de façon à ouvrir le transistor de puissance.

Dans l'exemple de la figure 2, les noeuds de sortie s1 des circuits de pilotage DRV sont directement connectés aux noeuds de commande des interrupteurs de puissance correspondants. Les noeuds d'entrée et des circuits de pilotage sont en revanche reliés aux noeuds de fourniture des signaux de commande CMD_HSA, respectivement CMD_HSB, respectivement CMD_HSC, respectivement CMD_LSA, respectivement CMD_LSB, respectivement CMD_LSC non pas directement, mais par l'intermédiaire d'interrupteurs de protection. Plus particulièrement, dans cet exemple, pour chacun des interrupteurs de puissance HSA, respectivement HSB, respectivement HSC, respectivement LSA, respectivement LSB, respectivement LSC, l'onduleur comprend un interrupteur de protection KHA, respectivement KHB, respectivement KHC, respectivement KLA, respectivement KLB, respectivement KLC ayant un premier noeud de conduction relié, par exemple connecté, au noeud de fourniture du signal de commande correspondant CMD_HSA, respectivement CMD_HSB, respectivement CMD_HSC, respectivement CMD_LSA, respectivement CMD_LSB, respectivement CMD_LSC de l'interrupteur de puissance, et un deuxième noeud de conduction relié, par exemple connecté, au noeud d'entrée e1 du circuit de pilotage DRV de l'interrupteur de puissance.

Sur la figure 2, par souci de simplification, seul l'interrupteur de protection KHA de l'interrupteur de puissance HSA a été représenté.

Dans l'exemple de la figure 2, pour chacun des interrupteurs de puissance, l'onduleur comprend en outre un circuit DET de détection de l'état ouvert ou fermé de l'interrupteur. Chaque circuit DET fournit, sur un noeud de sortie s1 du circuit, un signal binaire pouvant prendre deux états discrets représentatifs respectivement de l'état ouvert ou fermé de l'interrupteur de puissance correspondant. Plus particulièrement dans cet exemple, le circuit DET de l'interrupteur HSA fournit un signal HSA_ON représentatif de l'état ouvert ou fermé de l'interrupteur HSA, le circuit DET de l'interrupteur HSB fournit un signal HSB_ON représentatif de l'état ouvert ou fermé de l'interrupteur HSB, le circuit DET de l'interrupteur HSC fournit un signal HSC_ON représentatif de l'état ouvert ou fermé de l'interrupteur HSC, le circuit DET de l'interrupteur LSA fournit un signal LSA_ON représentatif de l'état ouvert ou fermé de l'interrupteur LSA, le circuit DET de l'interrupteur LSB fournit un signal LSB_ON représentatif de l'état ouvert ou fermé de l'interrupteur LSB, et le circuit DET de l'interrupteur LSC fournit un signal LSC_ON représentatif de l'état ouvert ou fermé de l'interrupteur LSC. Chacun des signaux HSA_ON, HSB_ON, HSC_ON, LSA_ON, LSB_ON et LSC_ON est par exemple à un état haut lorsque l'interrupteur de puissance correspondant est fermé (passant), et à un état bas lorsque l'interrupteur de puissance correspondant est ouvert (non passant).

Sur la figure 2, par souci de simplification, seul le circuit DET associé à l'interrupteur de puissance HSA a été représenté.

Dans l'exemple de la figure 2, pour chacun des interrupteurs de puissance HSA, respectivement HSB, respectivement HSC, respectivement LSA, respectivement LSB, respectivement LSC, l'onduleur comprend en outre un circuit CMD de commande de l'interrupteur de protection KHA, respectivement KHB, respectivement KHC, respectivement KLA, respectivement KLB, respectivement KLC de l'interrupteur de puissance.

Plus particulièrement, dans cet exemple, pour chaque interrupteur de puissance, le circuit CMD de commande de l'interrupteur de protection de l'interrupteur de puissance comprend deux noeuds d'entrée e1 et e2 reliés, par exemple connectés, respectivement aux noeuds de sortie s1 des circuits de détection DET des deux autres interrupteurs de puissance appartenant à la même cellule de commutation. Autrement dit les noeuds d'entrée e1 et e2 du circuit CMD de l'interrupteur HSA sont reliés, par exemple connectés, respectivement au noeud de sortie s1 du circuit DET de l'interrupteur HSB et au noeud de sortie s1 du circuit DET de l'interrupteur HSC, les noeuds d'entrée e1 et e2 du circuit CMD de l'interrupteur HSB sont reliés, par exemple connectés, respectivement au noeud de sortie s1 du circuit DET de l'interrupteur HSA et au noeud de sortie s1 du circuit DET de l'interrupteur HSC, les noeuds d'entrée e1 et e2 du circuit CMD de l'interrupteur HSC sont reliés, par exemple connectés, respectivement au noeud de sortie s1 du circuit DET de l'interrupteur HSA et au noeud de sortie s1 du circuit DET de l'interrupteur HSB, les noeuds d'entrée e1 et e2 du circuit CMD de l'interrupteur LSA sont reliés, par exemple connectés, respectivement au noeud de sortie s1 du circuit DET de l'interrupteur LSB et au noeud de sortie s1 du circuit DET de l'interrupteur LSC, les noeuds d'entrée e1 et e2 du circuit CMD de l'interrupteur LSB sont reliés, par exemple connectés, respectivement au noeud de sortie s1 du circuit DET de l'interrupteur LSA et au noeud de sortie s1 du circuit DET de l'interrupteur LSC, et les noeuds d'entrée e1 et e2 du circuit CMD de l'interrupteur LSC sont reliés, par exemple connectés, respectivement au noeud de sortie s1 du circuit DET de l'interrupteur LSA et au noeud de sortie s1 du circuit DET de l'interrupteur LSB.

Dans l'exemple de la figure 2, l'onduleur comprend en outre un circuit CUR_DET fournissant un signal binaire CUR_ON pouvant prendre deux états discrets représentatifs respectivement de la présence ou de l'absence d'un courant significatif dans l'onduleur. Le signal CUR_ON est par exemple à un état haut lorsqu'un courant significatif circule dans l'onduleur, et à un état bas lorsqu'il ne circule pas de courant significatif dans l'onduleur, par exemple lorsque l'onduleur n'est pas alimenté. Dans cet exemple, le circuit CUR_DET comprend un capteur de courant CI placé en série avec l'inductance d'entrée LIN, par exemple entre l'inductance LIN et le noeud A. Le capteur CI (non détaillé sur la figure) comprend par exemple une résistance de mesure placée en série avec l'inductance LIN, et un circuit de mesure d'une tension aux bornes de la résistance de mesure. Le capteur CI fournit par exemple une tension représentative de l'intensité du courant circulant dans l'inductance LIN. Le circuit CUR_DET comprend en outre un comparateur CMP comportant un premier noeud d'entrée e1 recevant la tension de sortie du capteur CI et un deuxième noeud d'entrée e2 sur lequel est appliqué un seuil de tension TH1 prédéterminé. Le comparateur comporte en outre un noeud de sortie s1 fournissant le signal de sortie CUR_ON du circuit CUR_DET. Ainsi, lorsque le signal de sortie du capteur de courant CI est supérieur au seuil TH1, c'est-à-dire lorsque le courant circulant dans l'inductance LIN est supérieur à un seuil prédéterminé, le signal de sortie CUR_ON du circuit CUR_DET est à un premier état, par exemple à l'état haut, et lorsque le signal de sortie du capteur de courant CI est inférieur au seuil TH1, le signal de sortie CUR_ON du circuit CUR_DET est à un deuxième état, par exemple à l'état bas.

Dans l'exemple de la figure 2, chaque circuit CMD comprend en outre un troisième noeud d'entrée e3 recevant le signal de sortie CUR_ON du circuit CUR_DET. Pour cela, chaque circuit de commande CMD peut avoir son noeud d'entrée e3 relié, par exemple connecté, au noeud de sortie s1 du comparateur CMP du circuit CUR_DET.

Chaque circuit CMD comprend en outre un noeud de sortie s1 relié, par exemple connecté, à un noeud de commande de l'interrupteur de protection KHA, respectivement KHB, respectivement KHC, respectivement KLA, respectivement KLB, respectivement KLC correspondant. Le circuit CMD de commande de l'interrupteur de protection KHA fournit sur son noeud de sortie s1 un signal CMD_KHA de commande de l'interrupteur KHA, le circuit CMD de commande de l'interrupteur de protection KHB fournit sur son noeud de sortie s1 un signal CMD_KHB de commande de l'interrupteur KHB, le circuit CMD de commande de l'interrupteur de protection KHC fournit sur son noeud de sortie s1 un signal CMD_KHC de commande de l'interrupteur KHC, le circuit CMD de commande de l'interrupteur de protection KLA fournit sur son noeud de sortie s1 un signal CMD_KLA de commande de l'interrupteur KLA, le circuit CMD de commande de l'interrupteur de protection KLB fournit sur son noeud de sortie s1 un signal CMD_KLB de commande de l'interrupteur KLB, et le circuit CMD de commande de l'interrupteur de protection KLC fournit sur son noeud de sortie s1 un signal CMD_KLC de commande de l'interrupteur KLC.

Sur la figure 2, par souci de simplification, seul le circuit CMD de commande de l'interrupteur de protection KHA a été représenté.

Dans l'exemple de la figure 2, dans chacune des cellules de commutation CELL1 et CELL2, pour chaque interrupteur de puissance de la cellule, le circuit CMD de commande de l'interrupteur de protection de l'interrupteur de puissance est configuré pour commander l'interrupteur de protection à l'état fermé lorsque au moins l'un des deux autres interrupteurs de puissance de la cellule est à l'état fermé ou lorsqu'aucun courant significatif ne circule dans l'inductance LIN, et pour commander l'interrupteur de protection à l'état ouvert lorsque chacun des deux autres interrupteurs de puissance de la cellule est à l'état ouvert et qu'un courant significatif circule dans l'inductance d'entrée LIN de l'onduleur. Pour cela, dans chaque circuit CMD, le signal de sortie du circuit CMD est généré en fonction des signaux reçus sur ses bornes d'entrée e1, e2 et e3.

En particulier, dans cet exemple, le signal CMD_KHA est à un premier état, par exemple un état haut, correspondant à un état de commande à l'état ouvert du transistor KHA, lorsque les signaux HSB_ON et HSC_ON sont tous les deux à l'état bas (interrupteurs HSB et HSC bloqués) et que le signal CUR_ON est à l'état haut (circulation d'un courant significatif dans l'onduleur), et le signal CMD_KHA est à un deuxième état, par exemple un état bas, correspondant à un état de commande à l'état fermé du transistor KHA, lorsqu'au moins un des signaux HSB_ON et HSC_ON est l'état haut (au moins un des interrupteurs HSB et HSC est passant) ou lorsque le signal CUR_ON est à l'état bas (pas de courant significatif dans l'onduleur).

De façon similaire, dans cet exemple chacun des circuits CMD commande l'ouverture de l'interrupteur de protection auquel il est associé lorsque les signaux reçus sur ses bornes d'entrée e1 et e2 sont tous les deux à l'état bas et que le signal reçu sur sa borne d'entrée e3 est à l'état haut, et commande la fermeture de l'interrupteur de protection lorsqu'au moins un des signaux reçus sur ses bornes e1 et e2 est à l'état haut ou lorsque le signal reçu sur sa borne e3 est à l'état bas.

L'onduleur de la figure 2 comprend en outre, pour chacun des interrupteurs de puissance HSA, HSB, HSC, LSA, LSB, LSC, une résistance R ayant une première extrémité connectée à la borne d'entrée e1 du circuit de pilotage DRV de l'interrupteur de puissance et une deuxième extrémité connectée à un noeud VON d'application d'une tension de commande à l'état fermé (passant) de l'interrupteur, par exemple la tension VDD.

Lorsque l'interrupteur de protection KHA, respectivement KHB, respectivement KHC, respectivement LSA, respectivement LSB, respectivement LSC de l'interrupteur de puissance est à l'état fermé, le signal de commande CMD_HSA, respectivement CMD_HSB, respectivement CMD_HSC, respectivement CMD_LSA, respectivement CMD_LSB, respectivement CMD_LSC fourni par le circuit de commande distante CTRL est appliqué sur le noeud d'entrée e1 du circuit de pilotage DRV de l'interrupteur de puissance, de façon à commander l'ouverture ou la fermeture de l'interrupteur de puissance (selon l'état du signal de consigne de commande fourni par le circuit de contrôle CTRL). Lorsque l'interrupteur de protection de l'interrupteur de puissance est à l'état ouvert, le signal de commande fourni par le circuit de commande distante CTRL n'est plus appliqué sur le noeud d'entrée e1 du circuit de pilotage DRV de l'interrupteur de puissance. Dans ce cas, la tension sur le noeud d'entrée e1 du circuit de pilotage DRV de l'interrupteur de puissance est tirée à la tension du noeud VON par la résistance R, ce qui conduit à forcer l'interrupteur de puissance à l'état fermé (passant).

L'ensemble comprenant le circuit de détection de courant CUR_DET, les interrupteurs de protection KHA, KHB, KHC, KLA, KLB, KLC, les résistances R, les circuits DET de détection d'état ouvert ou fermé des interrupteurs de puissance, et les circuits CMD de commande des interrupteurs de protection, forme un circuit de protection de l'onduleur contre une mise en circuit ouvert de sa source de courant d'entrée.

Ce circuit permet de garantir qu'à tout instant du fonctionnement de l'onduleur (lorsque l'onduleur est alimenté), au moins un interrupteur de puissance de la cellule CELL1 et au moins un interrupteur de puissance de la cellule CELL2 soient fermés. Ceci permet notamment de protéger l'onduleur en cas de défaillance du circuit de commande distante CTRL ou en cas de perte de connexion entre le circuit de commande distante CTRL et les circuits de commande rapprochée DRV.

Les signaux CMD_KHA, CMD_KHB, CMD_KHC, CMD_KLA, CMD_KLB et CMD_KLC peuvent en outre être transmis au circuit de contrôle CTRL, par exemple en vue de déclencher une alerte et/ou un arrêt de l'onduleur lorsque l'un des interrupteurs de protection est déclenché, c'est-à-dire commandé à l'état ouvert.

Les différents éléments du circuit de protection décrit ci-dessus peuvent être réalisés au moyen de composants discrets. A titre de variante, ces éléments peuvent être en totalité ou en partie intégrés dans une ou plusieurs puces semiconductrices. A titre d'exemple, pour chaque interrupteur de puissance, on peut prévoir une puce spécifique intégrant l'interrupteur de protection, le circuit DET et le circuit CMD de l'interrupteur de puissance. Dans ce cas, chaque puce de protection peut comporter quatre bornes ou pattes de connexion vers l'extérieur connectées respectivement au noeud de sortie s1 du circuit DET, et aux noeuds d'entrée e1, e2 et e3 du circuit CMD. Le circuit de pilotage DRV de l'interrupteur de puissance peut en outre être intégré sur la même puce, qui comportera alors une cinquième borne ou patte de connexion connectée au noeud de sortie s1 du circuit DRV.

De préférence, les interrupteurs de protection KHA, KHB, KHC, KLA, KLB, KLC sont des interrupteurs normalement fermés (passants), par exemple des transistors normalement fermés. Ceci permet que les interrupteurs de protection soient directement en configuration fermée lors de la mise sous tension de l'onduleur. A titre de variante, les interrupteurs de protection KHA, KHB, KHC, KLA, KLB, KLC peuvent être des interrupteurs normalement ouverts.

On notera que dans l'exemple décrit en relation avec la figure 2, la prise en compte du signal de sortie CUR_ON du circuit CUR_DET pour décider de déclencher ou non la protection, c'est-à-dire l'ouverture d'un interrupteur de protection, permet de désactiver la sécurité au démarrage de l'onduleur, ou lorsque l'onduleur est à l'arrêt. Le seuil de courant à partir duquel la sécurité est activée (défini par le seuil TH1) peut être fixé par l'utilisateur.

A titre de variante, les interrupteurs de protection KHA, KHB, KHC, KLA, KLB, KLC peuvent être commandés sans tenir compte de la présence ou non d'un courant significatif dans l'onduleur. Dans ce cas, dans chacune des cellules de commutation CELL1 et CELL2, pour chaque interrupteur de puissance de la cellule, le circuit CMD est configuré pour commander l'interrupteur de protection à l'état fermé lorsque au moins l'un des deux autres interrupteurs de puissance de la cellule est à l'état fermé, et pour commander l'interrupteur de protection à l'état ouvert lorsque chacun des deux autres interrupteurs de puissance de la cellule est à l'état ouvert. Le circuit de détection CUR_DET et les entrées e3 des circuits CMD peuvent alors être omis.

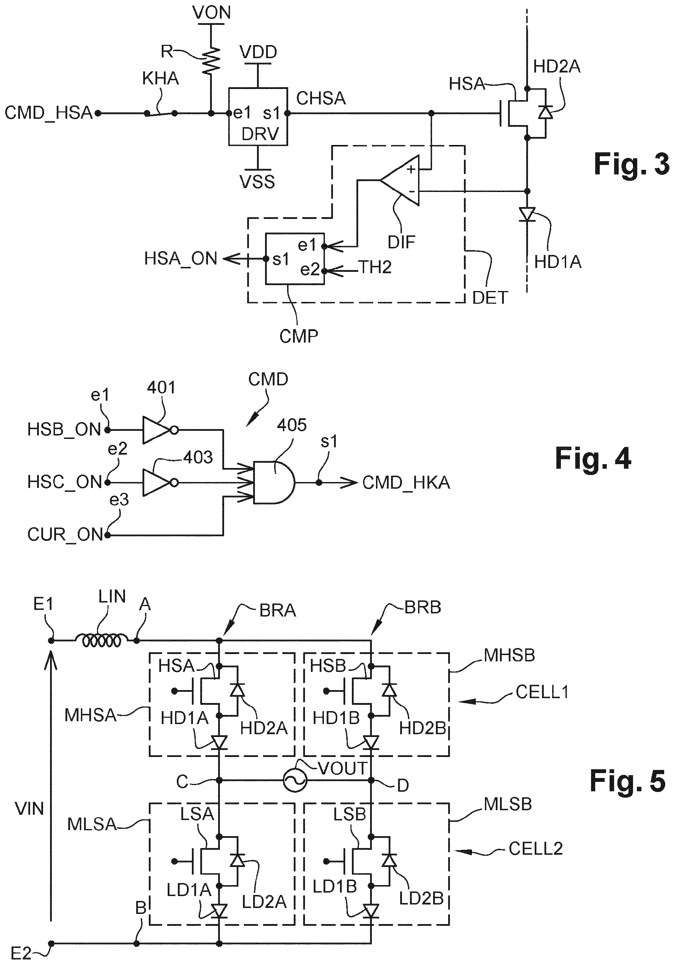

La figure 3 représente plus en détail un exemple de réalisation d'un circuit DET de détection de l'état ouvert ou fermé d'un interrupteur de puissance de l'onduleur de la figure 2. Sur la figure 3, le circuit DET détaillé est celui de l'interrupteur de puissance HSA de l'onduleur, étant entendu que les circuits DET des autres interrupteurs de puissance peuvent être identiques ou similaires. La figure 3 reprend en outre les mêmes éléments que la figure 2, à l'exception de l'inductance d'entrée LIN, du circuit de détection de courant d'entrée CUR_DET, et du circuit CMD qui n'ont pas été reproduits par souci de simplification.

Dans cet exemple, le circuit DET comprend un circuit DIF de mesure différentielle de tension ayant une borne d'entrée positive (+) reliée, par exemple connectée, à la borne de commande de l'interrupteur de puissance HSA et une borne d'entrée négative (-) reliée, par exemple connectée, à la borne de conduction de l'interrupteur HSA située côté anode de la diode HD1A. Le circuit DIF comprend en outre une borne de sortie fournissant un signal représentatif de la tension entre sa borne positive (+) et sa borne négative (-). Le circuit DET comprend de plus un comparateur CMP comportant un premier noeud d'entrée e1 recevant la tension de sortie du circuit DIF et un deuxième noeud d'entrée e2 sur lequel est appliqué un seuil de tension TH2 prédéterminé. Le comparateur comporte en outre un noeud de sortie s1 correspondant au noeud de sortie s1 du circuit DET, fournissant le signal de sortie HSA_ON du circuit DET. Ainsi, lorsque le signal de sortie du circuit de mesure de tension DIF est supérieur au seuil TH2, c'est-à-dire lorsque la tension entre le noeud de commande et le noeud de conduction de l'interrupteur HSA est supérieure au seuil TH2, le signal de sortie HSA_ON du circuit DET est à un premier état, par exemple à l'état haut, indiquant qu'un signal de commande à l'état fermé (passant) est appliqué à l'interrupteur HSA, et, lorsque le signal de sortie du circuit DIF est inférieur au seuil TH2, le signal de sortie HSA_ON du circuit DET est à un deuxième état, par exemple à l'état bas, indiquant qu'un signal de commande à l'état ouvert (non passant) est appliqué à l'interrupteur HSA.

Dans cet exemple, les interrupteurs de puissance peuvent être des transistors à effet de champ, par exemple des transistors MOS. La tension mesurée par le circuit DIF correspond alors à la tension grille-source du transistor de puissance. Dans ce cas, le seuil TH2 est par exemple supérieur ou égal à la tension de seuil ou tension de mise en conduction du transistor.

Plus généralement, tout autre circuit de détection permettant de détecter l'état ouvert ou fermé du transistor de puissance peut être utilisé, par exemple un circuit de détection comportant un capteur de courant placé en série de l'interrupteur de puissance, ou encore un circuit mesurant le signal CMD_HSA reçu sur la borne d'entrée e1 du circuit de pilotage DRV, ou encore un circuit mesurant la tension entre les bornes de conduction de l'interrupteur de puissance (tension drain-source dans le cas d'un transistor MOS).

La figure 4 représente plus en détail un exemple de réalisation d'un circuit CMD de commande d'un interrupteur de protection de l'onduleur de la figure 2. Sur la figure 4, le circuit CMD détaillé est celui de l'interrupteur de protection KHA de l'interrupteur de puissance HSA de l'onduleur, étant entendu que les circuits CMD des autres interrupteurs de protection peuvent être identiques ou similaires à celui de la figure 4.

Dans cet exemple, le circuit CMD comprend deux portes NON 401 et 403 et une porte ET 405 à trois entrées et une sortie. La porte NON 401 a un noeud d'entrée relié, par exemple connecté, au noeud d'entrée e1 du circuit CMD, et un noeud de sortie relié, par exemple connecté, à un premier noeud d'entrée de la porte ET 405. La porte NON 403 a un noeud d'entrée relié, par exemple connecté, au noeud d'entrée e2 du circuit CMD, et un noeud de sortie relié, par exemple connecté, à un deuxième noeud d'entrée de la porte ET 405. Dans cet exemple, le troisième noeud d'entrée de la porte ET 405 est directement relié, par exemple connecté, au noeud d'entrée e3 du circuit CMD. La sortie de la porte ET 405 est reliée, par exemple connectée, au noeud de sortie s1 du circuit CMD.

Dans le cas où la commande des interrupteurs de protection ne tient pas compte du signal CUR_ON, la porte ET 405 peut être remplacée par une porte ET à deux entrées et une sortie.

On a décrit ci-dessus un exemple de réalisation d'un circuit de protection d'un onduleur à source de courant triphasé. Les modes de réalisation décrits peuvent toutefois être adaptés à la protection d'un onduleur à source de courant monophasé.

La figure 5 est un schéma électrique simplifié d'un exemple d'un onduleur à source de courant monophasé, c'est-à-dire générant une tension de sortie alternative VOUT monophasée à partir d'une tension d'entrée continue VIN.

L'onduleur de la figure 5 diffère de l'onduleur de la figure 1 essentiellement en ce qu'il ne comprend pas le bras BRC ni le noeud de référence GND. Dans l'onduleur de la figure 5, la tension alternative de sortie VOUT est délivrée entre les noeuds C et D.

Ainsi, dans l'onduleur de la figure 5, chacune des cellules de commutation CELL1 et CELL2 comprend uniquement deux interrupteurs de puissance, au lieu de trois dans l'onduleur de la figure 1.

Le circuit de protection décrit en relation avec les figures 2 à 4 peut être adapté à l'onduleur monophasé de la figure 5. En particulier, dans le cas d'un onduleur monophasé, dans chacune des cellules de commutation CELL1 et CELL2, pour chacun des deux interrupteurs de puissance de la cellule, le circuit CMD de commande de l'interrupteur de protection de l'interrupteur de puissance est configuré pour commander l'interrupteur de protection à l'état fermé lorsque l'autre interrupteur de puissance de la cellule est à l'état fermé (ou lorsqu'aucun courant significatif ne circule dans l'inductance LIN dans le cas où il est tenu compte du signal CUR_ON pour commander les interrupteurs de protection), et pour commander l'interrupteur de protection à l'état ouvert lorsque l'autre interrupteur de puissance de la cellule est à l'état ouvert (et qu'un courant significatif circule dans l'inductance d'entrée LIN de l'onduleur dans le cas où il est tenu compte du signal CUR_ON pour commander les interrupteurs de protection). Autrement dit, par rapport à l'exemple des figures 2 et 4, le noeud d'entrée e2 du circuit CMD peut être omis. Par rapport à l'exemple de la figure 4, la porte NON 403 peut être omise, et la porte ET 405 de la figure 4 peut être remplacée par une porte ET à deux entrées et une sortie, ou omise dans le cas où il n'est pas tenu compte du signal CUR_ON pour commander les interrupteurs de protection (la sortie de la porte NON 401 étant alors directement reliée, par exemple connectée, au noeud de sortie s1 du circuit CMD).

Divers modes de réalisation et variantes ont été décrits. La personne du métier comprendra que certaines caractéristiques de ces divers modes de réalisation et variantes pourraient être combinées, et d'autres variantes apparaîtront à l'homme de l'art. En particulier, les modes de réalisation décrits ne se limitent pas à l'exemple particulier de réalisation du circuit CMD décrit en relation avec la figure 4. Plus généralement, la personne du métier saura prévoir d'autres implémentations du circuit CMD, ou encore du circuit DET ou du circuit CUR_DET, à partir des indications fonctionnelles de la présente description.

## Revendications

1. Onduleur à source de courant, comportant :
- une première cellule de commutation (CELL1) comportant au moins des premier (HSA) et deuxième (HSB) interrupteurs de puissance reliant un même premier noeud d'entrée (E1) de l'onduleur respectivement à des premier (C) et deuxième (D) noeuds de sortie de l'onduleur ; et
- un circuit de protection contre une mise en circuit ouvert d'une source de courant d'entrée de l'onduleur, comportant, pour chaque interrupteur de puissance de la première cellule de commutation (CELL1) :
∘ un interrupteur de protection (KHA) reliant un noeud de fourniture d'un signal de consigne de commande (CMD_HSA) de l'interrupteur de puissance à un noeud de commande de cet interrupteur de puissance ;
∘ un circuit (DET) de détection de l'état ouvert ou fermé de cet interrupteur de puissance ; et
∘ un circuit (CMD) de commande de l'interrupteur de protection (KHA) recevant un signal de sortie (HSB_ON, HSC_ON) du circuit de détection (DET) du ou des autres circuits de protection du ou des autres interrupteurs de puissance de la première cellule de commutation,
dans lequel, pour chaque interrupteur de puissance de la première cellule de commutation (CELL1), le circuit de commande (CMD) de l'interrupteur de protection (KHA) de l'interrupteur de puissance est configuré pour commander l'interrupteur de protection (KHA) à l'état fermé lorsqu'au moins l'un du ou des autres interrupteurs de puissance de la première cellule de commutation est à l'état fermé, et pour commander l'interrupteur de protection à l'état ouvert lorsqu'aucun autre interrupteur de puissance de la première cellule de commutation n'est à l'état fermé,
l'onduleur comportant en outre, pour chaque interrupteur de puissance, un circuit de pilotage ou circuit de commande rapprochée (DRV) ayant un noeud d'entrée (e1) connecté au noeud de conduction de l'interrupteur de protection opposé au noeud de fourniture du signal de consigne de commande (CMD_HSA) de l'interrupteur de puissance, et un noeud de sortie (s1) connecté au noeud de commande de l'interrupteur de puissance,
dans lequel le circuit de protection comprend en outre, pour chaque interrupteur de puissance, une résistance (R) ayant une première extrémité connectée à un noeud de conduction de l'interrupteur de protection opposé au noeud de fourniture du signal de consigne de commande (CMD_HSA) de l'interrupteur de puissance, et une deuxième extrémité connectée à un noeud (VON) d'application d'une tension de commande à l'état fermé de l'interrupteur de puissance.

2. Onduleur selon la revendication 1, dans lequel la première cellule de commutation (CELL1) comprend en outre un troisième interrupteur de puissance (HSC) reliant le premier noeud d'entrée (E1) de l'onduleur à un troisième noeud de sortie (E) de l'onduleur.

3. Onduleur selon la revendication 1 ou 2, comportant en outre une deuxième cellule de commutation (CELL2) comportant au moins des premier (LSA) et deuxième (LSB) interrupteurs de puissance reliant respectivement les premier (C) et deuxième (D) noeuds de sortie de l'onduleur à un même deuxième noeud d'entrée (E2) de l'onduleur, et dans lequel le circuit de protection comporte, pour chaque interrupteur de puissance de la deuxième cellule de commutation (CELL2) :
- un interrupteur de protection reliant un noeud de fourniture d'un signal de commande de l'interrupteur de puissance à un noeud de commande de l'interrupteur de puissance ;
- un circuit (DET) de détection de l'état ouvert ou fermé de l'interrupteur de puissance ; et
- un circuit (CMD) de commande de l'interrupteur de protection recevant, pour chacun du ou des autres interrupteurs de puissance de la deuxième cellule de commutation, un signal de sortie du circuit de détection (DET) de l'autre interrupteur de puissance.

4. Onduleur selon la revendication 3, dans lequel, pour chaque interrupteur de puissance de la deuxième cellule de commutation (CELL2), le circuit de commande (CMD) de l'interrupteur de protection de l'interrupteur de puissance est configuré pour commander l'interrupteur de protection à l'état fermé lorsqu'au moins l'un du ou des autres interrupteurs de puissance de la deuxième cellule de commutation est à l'état fermé, et pour commander l'interrupteur de protection à l'état ouvert lorsqu'aucun autre interrupteur de puissance de la deuxième cellule de commutation (CELL2) n'est à l'état fermé.

5. Onduleur selon la revendication 3 ou 4 dans lequel la deuxième cellule de commutation (CELL2) comprend en outre un troisième interrupteur de puissance reliant un troisième noeud de sortie (E) de l'onduleur au deuxième noeud d'entrée (E2) de l'onduleur.

6. Onduleur selon l'une quelconque des revendications 1 à 5, comportant en outre un circuit (CUR_DET) de détection de présence d'un courant d'entrée dans l'onduleur, chaque circuit de commande (CMD) recevant un signal de sortie (CUR_ON) du circuit (CUR_DET) de détection de présence d'un courant d'entrée et étant configuré pour commander l'ouverture de l'interrupteur de protection auquel il est associé uniquement lorsqu'un courant d'entrée est détecté dans l'onduleur.

7. Onduleur selon l'une quelconque des revendications 1 à 6, comportant en outre un circuit de contrôle ou circuit de commande distante (CTRL) commun à l'ensemble des interrupteurs de puissance et fournissant les signaux de consigne de commande des différents interrupteurs de puissance.

8. Onduleur selon l'une quelconque des revendications 1 à 7, dans lequel, pour chaque interrupteur de puissance, le circuit (DET) de détection de l'état ouvert ou fermé de l'interrupteur de puissance comprend un circuit de mesure différentielle d'une tension entre le noeud de commande de l'interrupteur de puissance et un noeud de conduction de l'interrupteur de puissance.

9. Onduleur selon l'une quelconque des revendications 1 à 7, dans lequel, pour chaque interrupteur de puissance, le circuit (DET) de détection de l'état ouvert ou fermé de l'interrupteur de puissance comprend un capteur de courant placé en série de l'interrupteur de puissance.

10. Onduleur selon l'une quelconque des revendications 1 à 7, dans lequel, pour chaque interrupteur de puissance, le circuit (DET) de détection de l'état ouvert ou fermé de l'interrupteur de puissance comprend un circuit mesurant la tension entre les bornes de conduction de l'interrupteur de puissance.

## Patentansprüche

1. Ein Stromquelleninverter, der Folgendes aufweist:
- eine erste Schaltzelle (CELL1), die wenigstens erste (HSA) und zweite (HSB) Leistungsschalter aufweist, die einen gleichen ersten Eingangsknoten (E1) des Inverters zu jeweiligen ersten (C) und zweiten (D) Ausgangsknoten des Inverters koppeln; und
- eine Schaltung zum Schutz gegen einen Leerlauf einer Eingangsstromquelle des Inverters, wobei die Schaltung für jeden Leistungsschalter der ersten Schaltzelle (CELL1) Folgendes aufweist:
o ein Schutzschalter (KHA), der einen Knoten zum Liefern eines Sollwertsignals (CMD_HSA) zum Steuern dieses Leistungsschalters mit einem Steuerknoten des Leistungsschalters koppelt;
o eine Schaltung (DET) zum Detektieren des AN- oder AUS-Zustands dieses Leistungsschalters; und
o eine Schaltung (CMD) zum Steuern des Schutzschalters (KHA), die ein Ausgangssignal (HSB_ON, HSC_ON) von der Detektionsschaltung (DET) der einen oder verschiedener anderer Schutzschaltungen des einen oder verschiedener anderer Leistungsschalter der ersten Schaltzelle empfängt,
wobei, für jeden Leistungsschalter der ersten Schaltzelle (CELL1), die Steuerschaltung (CMD) des Schalters (KHA) zum Schutz des Leistungsschalters konfiguriert ist zum Steuern des Schutzschalters (KHA) in den AN-Zustand, wenn wenigstens einer der anderen Leistungsschalter der ersten Schaltzelle im AN-Zustand ist, und zum Steuern des Schutzschalters in den AUS-Zustand, wenn kein anderer Leistungsschalter der ersten Schaltzelle im AN-Zustand ist,
wobei der Inverter ferner, für jeden Leistungsschalter, eine Treiberschaltung oder geschlossene Steuerschaltung (DRV) aufweist mit einem Eingangsknoten (e1), der mit dem Leitungsknoten des Schutzschalters gegenüber des Knotens zum Liefern des Sollwertsignals (CMD_HSA) zum Steuern dieses Leistungsschalters verbunden ist, und mit einem Ausgangsknoten (s1), der mit dem Steuerknoten des Leistungsschalters verbunden ist,
wobei die Schutzschaltung ferner, für jeden Leistungsschalter, einen Widerstand (R) aufweist mit einem ersten Ende, das mit einem Leitungsknoten des Schutzschalters gegenüber des Knotens zum Liefern des Sollwertsignals (CMD_HSA) zum Steuern dieses Leistungsschalters verbunden ist, und mit einem zweiten Ende, das mit einem Knoten (VON) zum Anlegen einer Steuerspannung im AN-Zustand des Leistungsschalters verbunden ist.

2. Der Inverter nach Anspruch 1, wobei die erste Schaltzelle (CELL1) ferner einen dritten Leistungsschalter (HSC) aufweist, der den ersten Eingangsknote (E1) des Inverters zu einem dritten Ausgansknoten (E) des Inverters koppelt.

3. Der Inverter nach Anspruch 1 oder 2, ferner aufweisend eine zweite Schaltzelle (CELL2), die wenigstens erste (LSA) und zweite (LSB) Leistungsschalter aufweist, die jeweils die ersten (C) und zweiten (D) Ausgangsknoten des Inverters zu einem gleichen zweiten Eingangsknoten (E2) des Inverters koppeln, und wobei die Schutzschaltung für jeden Leistungsschalter der zweiten Schaltzelle (CELL2) Folgendes aufweist:
- einen Schutzschalter, der einen Knoten zum Liefern eines Steuersignals des Leistungsschalters mit einem Steuerknoten des Leistungsschalters koppelt;
- eine Schaltung (DET) zum Detektieren des AN- oder AUS-Zustands des Leistungsschalters; und
- eine Schaltung (CMD) zum Steuern des Schutzschalters, die für jeden der anderen Leistungsschalter der zweiten Schaltzelle ein Ausgangssignal von der Detektionsschaltung (DET) des anderen Leistungsschalters empfängt.

4. Der Inverter nach Anspruch 3, wobei, für jeden Leistungsschalter der zweiten Schaltzelle (CELL2), die Steuerschaltung (CMD) des Schalters zum Schutz des Leistungsschalters konfiguriert ist zum Steuern des Schutzschalters in den AN-Zustand, wenn wenigstens einer der anderen Leistungsschalter der zweiten Schaltzelle im AN-Zustand ist, und zum Steuern des Schutzschalters in den AUS-Zustand, wenn keiner der Leistungsschalter der zweiten Schaltzelle (CELL2) im AN-Zustand ist.

5. Der Inverter nach Anspruch 3 oder 4, wobei die zweite Schaltzelle (CELL2) ferner einen dritten Leistungsschalter aufweist, der einen dritten Ausgansknoten (E) des Inverters zu dem zweiten Eingangsknoten (E2) des Inverters koppelt.

6. Der Inverter nach einem der Ansprüche 1 bis 5, ferner aufweisend eine Schaltung (CUR_DET) zum Detektieren der Anwesenheit eines Eingangsstroms des in den Inverter, wobei jede Steuerschaltung (CMD) ein Ausgangssignal (CUR_ON) der Schaltung (CUR_DET) zum Detektieren der Anwesenheit eines Eingangsstroms empfängt und konfiguriert ist den Schutzschalter, mit dem sie verknüpft ist, genau dann in den AUS-Zustand zu Steuern, wenn ein Eingangsstrom in dem Inverter detektiert wird.

7. Der Inverter nach einem der Ansprüche 1 bis 6, ferner aufweisend eine Steuerschaltung oder Fernsteuerschaltung (CTRL), die allen Leistungsschaltern gemeinsam ist und die Sollwertsignale zum Steuern der verschiedenen Leistungsschalter liefert.

8. Der Inverter nach einem der Ansprüche 1 bis 7, wobei, für jeden Leistungsschalter, die Schaltung (DET) zum Detektieren des AUS- oder AN-Zustands des Leistungsschalters eine Schaltung aufweist zum differentiellen Messen einer Spannung zwischen dem Steuerknoten des Leistungsschalters und einem Leitungsknoten des Leistungsschalters.

9. Der Inverter nach einem der Ansprüche 1 bis 7, wobei, für jeden Leistungsschalter, die Schaltung (DET) zum Detektieren des AUS- oder AN-Zustands des Leistungsschalters einem Stromsensor in Reihe mit dem Leistungsschalter aufweist.

10. Der Inverter nach einem der Ansprüche 1 bis 7, wobei, für jedem Leistungsschalter, die Schaltung (DET) zum Detektieren des AUS- oder AN-Zustands des Leistungsschalters eine Schaltung aufweist zum Messen der Spannung zwischen den Leitungsanschlüssen des Leistungsschalters.

## Claims

1. A current source inverter, comprising:
- a first switching cell (CELL1) comprising at least first (HSA) and second (HSB) power switches coupling a same first input node (E1) of the inverter respectively to first (C) and second (D) output nodes of the inverter; and
- a circuit of protection against a placing in open circuit of an input current source of the inverter, comprising, for each power switch of the first switching cell (CELL1):
∘ a protection switch (KHA) coupling a node for supplying a set point signal (CMD_HSA) for controlling this power switch to a control node of the power switch;
oa circuit (DET) for detecting the off or on state of this power switch; and
∘ a circuit (CMD) for controlling the protection switch (KHA) receiving an output signal (HSB_ON, HSC_ON) of the detection circuit (DET) of the one or several other circuits of protection of the one or several other power switches of the first switching cell,
wherein, for each power switch of the first switching cell (CELL1), the control circuit (CMD) of the switch (KHA) for protecting the power switch is configured to control the protection switch (KHA) to the on state when at least one of the other power switch(es) of the first switching cell is in the on state, and to control the protection switch to the off state when no other power switch of the first switching cell is in the on state,
the inverter further comprising, for each power switch, a driver circuit or close control circuit (DRV) having an input node (e1) connected to the conduction node of the protection switch opposite to the node for supplying the set point signal (CMD_HSA) for controlling the power switch, and an output node (s1) connected to the power switch control node, wherein the protection circuit further comprises, for each power switch, a resistor (R) having a first end connected to a conduction node of the protection switch opposite to the node for supplying the set point signal (CMD_HSA) for controlling the power switch, and a second end connected to a node (VON) of application of a control voltage in the on state of the power switch.

2. The inverter according to claim 1, wherein the first switching cell (CELL1) further comprises a third power switch (HSC) coupling the first input node (E1) of the inverter to a third output node (E) of the inverter.

3. The inverter according to claim 1 or 2, further comprising a second switching cell (CELL2) comprising at least first (LSA) and second (LSB) power switches respectively coupling the first (C) and second (D) output nodes of the inverter to a same second input node (E2) of the inverter, and wherein the protection circuit comprises, for each power switch of the second switching cell (CELL2):
- a protection switch coupling a node for supplying a control signal of the power switch to a control node of the power switch;
- a circuit (DET) for detecting the off or on state of the power switch; and
- a circuit (CMD) for controlling the protection switch receiving, for each of the other power switch(es) of the second switching cell, an output signal of the detection circuit (DET) of the other power switch.

4. The inverter according to claim 3, wherein, for each power switch of the second switching cell (CELL2), the control circuit (CMD) of the switch for protecting the power switch is configured to control the protection switch to the on state when at least one of the other power switch (es) of the second switching cell is in the on state, and to control the protection switch to the off state when no other power switch of the second switching cell (CELL2) is in the on state.

5. The inverter according to claim 3 or 4, wherein the second switching cell (CELL2) further comprises a third power switch coupling a third output node (E) of the inverter to the second input node (E2) of the inverter.

6. The inverter according to any of claims 1 to 5, further comprising a circuit (CUR_DET) for detecting the presence of an input current in the inverter, each control circuit (CMD) receiving an output signal (CUR_ON) of the circuit (CUR_DET) for detecting the presence of an input current and being configured to control the protection switch with which it is associated to the off state only when an input current is detected in the inverter.

7. The inverter according to any of claims 1 to 6, further comprising a control circuit or remote control circuit (CTRL) common to all the power switches and supplying the set point signals for controlling the different power switches.

8. The inverter according to any of claims 1 to 7, wherein, for each power switch, the circuit (DET) for detecting the off or on state of the power switch comprises a circuit of differential measurement of a voltage between the control node of the power switch and a conduction node of the power switch.

9. The inverter according to any of claims 1 to 7, wherein, for each power switch, the circuit (DET) for detecting the off or on state of the power switch comprises a current sensor in series with the power switch.

10. The inverter according to any of claims 1 to 7, wherein, for each power switch, the circuit (DET) for detecting the off or on state of the power switch comprises a circuit for measuring the voltage between the conduction terminals of the power switch.
